# EUROPEAN PATENT APPLICATION

(11) **EP 4 752 935 A1**
(43) Date of publication of application: **03.06.2026**
(21) Application number: 23949820.7
(22) Date of filing: 22.08.2023
(51) Int. Cl.: H01L 23/00, H01L 25/075, H01L 21/683, H10H 20/00

(54) **TRANSFER SUBSTRATE ASSEMBLY AND METHOD FOR MANUFACTURING DISPLAY DEVICE BY USING SAME**

(71) Applicant: LG Electronics Inc., Yeongdeungpo-gu Seoul 07336 (KR)
(72) Inventor: OH, Donghae, Seoul 06772 (KR); HWANG, Sunghyun, Seoul 06772 (KR); KANG, Byungjun, Seoul 06772 (KR)
(74) Representative: Schott, Jakob Valentin
(86) International application number: PCT/KR2023/012413
(87) International publication number: WO 2025/041880

(57) **Abstract**

The present disclosure is applicable to display device-related technical fields, and relates to, for example, a micro-light emitting diode (micro-LED), a transfer substrate assembly, and a method for manufacturing a display device by using same. The present disclosure provides a transfer substrate assembly for transferring a light emitting element, and the transfer substrate assembly may comprise: a transfer substrate including a first surface where a rough surface is formed; an adhesive layer locally positioned on the first surface of the transfer substrate; and a light emitting element attached by means of the adhesive layer.

## Description

### [Technical Field]

The present disclosure is applicable to a technical field related to display devices, and relates to, for example, a micro light emitting diode (LED), a transfer substrate assembly, and a method for manufacturing a display device using the same.

### [Background]

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

However, LCDs have problems in that response times are not short and flexible implementation is difficult, and OLEDs have problems in that lifespans are short and mass production yields are not good.

On the other hand, LED (light emitting diode), which is a well-known semiconductor light emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light emitting element may be proposed. Such light emitting diode has various advantages, such as long lifespan, low power consumption, excellent initial driving characteristics, high vibration resistance, and the like, compared to a filament-based light emitting element.

AuGe alloy metals, which are commonly used for electrical characteristics of n-type electrodes, have low reflectivity. Moreover, the reflectivity of AuGe alloys is reduced to a level of about 20% after heat treatment for forming ohmic contacts.

Various metal layer structures have been attempted to solve such a problem, but it is difficult to satisfy both electrical and optical characteristics at the same time.

To solve such a problem, a form in which an ohmic contact is partially formed and a reflective film is formed on a remaining portion has also been proposed. However, because light emitting element chips have a size on a micro-scale, there is a difficulty in structural implementation.

In addition, a reflective film covering an entire n-type semiconductor layer in an alloy form has also been proposed, but reflection efficiency may be lowered compared to that of a single metal.

In addition, in particular, a gold (Au) reflective film mainly used in red light emitting elements has a high manufacturing cost, and causes inter-diffusion with aluminum (Al) used as a bridge metal in a display device, thereby forming nonuniform inter-metallic compound (IMC).

Kirkendall voids may be formed in an Au-rich region due to a high diffusion rate at such an Al-Au interface. Such voids not only increase resistance by reducing an area through which current may flow, but also cause reliability issues in the long run.

Therefore, there is a need for a method capable of solving such problems.

### [Summary]

### [Technical Problem]

The present disclosure is intended to provide a transfer substrate assembly and a method for manufacturing a display device using the same capable of increasing adhesive strength of an adhesive layer that adheres a light emitting element to a transfer substrate.

In addition, the present disclosure is intended to provide a transfer substrate assembly and a method for manufacturing a display device using the same capable of securing a sufficient alignment margin even when a micro light emitting element is used.

In addition, the present disclosure is intended to provide a transfer substrate assembly and a method for manufacturing a display device using the same capable of also reducing the area of a sacrificial layer for dispersion of a light emitting element.

In addition, the present disclosure is intended to provide a transfer substrate assembly and a method for manufacturing a display device using the same capable of reducing the dispersion time of a light emitting element and thus improving productivity.

Furthermore, an embodiment of the present disclosure is to solve various problems not mentioned herein. Such problems will be understood by those skilled in the art from the overall disclosure of the present document and the drawings.

### [Technical Solutions]

As a first aspect to solve the above problems, the present disclosure provides a transfer substrate assembly configured to transfer a light emitting element, the transfer substrate assembly comprising: a transfer substrate including a first surface where a rough surface is formed; an adhesive layer locally positioned on the first surface of the transfer substrate; and a light emitting element attached by the adhesive layer.

In one implementation of the first aspect, the transfer substrate assembly may further comprise a sacrificial layer disposed between the adhesive layer and the light emitting element.

In one implementation of the first aspect, a width or a diameter of the sacrificial layer may be greater than a width or a diameter of the adhesive layer.

In one implementation of the first aspect, a width or a diameter of the sacrificial layer may be equal to or smaller than a width or a diameter of a contact surface of the light emitting element.

In one implementation of the first aspect, the transfer substrate may be a sapphire substrate.

In one implementation of the first aspect, the rough surface may be a surface obtained by wet-etching a first surface of the sapphire substrate.

In one implementation of the first aspect, the rough surface may include an uneven pattern increasing a surface area of the first surface of the transfer substrate.

As a second aspect to solve the above problems, the present disclosure provides a method for manufacturing a display device including a light emitting element, the method comprising: forming a sacrificial layer on an individual light emitting element separately partitioned on a growing substrate; forming an adhesive layer on the sacrificial layer; attaching the adhesive layer to a first surface of a transfer substrate where a rough surface is formed; and removing the growing substrate.

In one implementation of the second aspect, the method may further comprise removing the sacrificial layer to separate the individual light emitting element from the first surface of the transfer substrate.

In one implementation of the second aspect, the removing of the sacrificial layer may include etching the sacrificial layer in a fluid to disperse the individual light emitting element into the fluid.

### [Advantageous Effects]

According to an embodiment of the present disclosure, there are the following effects.

First, according to an embodiment of the present disclosure, because the size of the adhesive layer that adheres the light emitting element to the transfer substrate may be reduced, a sufficient alignment margin may be secured even when using the micro light emitting element.

In addition, the adhesive layer may have sufficient adhesive strength to attach the light emitting element to the transfer substrate. Accordingly, loss of the light emitting elements may be reduced during the manufacturing process.

In addition, a problem in dispersion may not occur due to an alignment error. Further, the area of the sacrificial layer for dispersion of the light emitting element may also be reduced.

In addition, according to an embodiment of the present disclosure, the size of the adhesive layer pattern may be reduced, and thus the size and thickness of the sacrificial layer may be reduced. Accordingly, the dispersion time of the light emitting element may be reduced. Accordingly, productivity may be improved.

Furthermore, according to another embodiment of the present disclosure, there are additional effects not mentioned herein. Such additional effects will be understood by those skilled in the art from the overall disclosure of the present document and the drawings.

### [Brief Description of the Drawings]

FIG. 1 is a conceptual diagram illustrating an embodiment of a display device using a semiconductor light emitting element according to the present disclosure.
FIG. 2 is a partially enlarged diagram showing a part A shown in FIG. 1.
FIGS. 3A and 3B are cross-sectional diagrams taken along the cutting lines B-B and C-C in FIG. 2.
FIG. 4 is a conceptual diagram illustrating the flip-chip type semiconductor light emitting element of FIGS. 3A and 3B.
FIGS. 5A to 5C are conceptual diagrams illustrating various examples of color implementation with respect to a flip-chip type semiconductor light emitting element.
FIG. 6 shows cross-sectional views of a method of fabricating a display device using a semiconductor light emitting element according to the present disclosure.
FIG. 7 is a perspective diagram of a display device using a semiconductor light emitting element according to another embodiment of the present disclosure.
FIG. 8 is a cross-sectional diagram taken along a cutting line D-D shown in FIG. 8.
FIG. 9 is a conceptual diagram showing a vertical type semiconductor light emitting element shown in FIG. 8.
FIGS. 10 to 14 are cross-sectional views showing some steps of a manufacturing process of a display device including a light emitting element according to an embodiment of the present disclosure.
FIG. 15 is a photograph showing a portion of a transfer substrate assembly according to an embodiment of the present disclosure.
FIG. 16 is an enlarged photograph of a portion A in FIG. 15.
FIG. 17 is a cross-sectional view illustrating a state in which an individual light emitting element is dispersed during a process of manufacturing a display device including light emitting elements according to an embodiment of the present disclosure.
FIG. 18 is a view for illustrating respective alignment margins of a transfer substrate assembly according to a comparative example and a transfer substrate assembly according to an embodiment of the present disclosure.
FIG. 19 is a photograph showing a state in which light emitting elements are bonded to a transfer substrate according to a comparative example.
FIG. 20 is a photograph showing a state in which light emitting elements are bonded to a transfer substrate according to an embodiment of the present disclosure.
FIGS. 21 and 22 are schematic views showing a manufacturing process of a display device according to an embodiment of the present disclosure.
FIG. 23 is a cross-sectional view showing a display device according to an embodiment of the present disclosure.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting element mentioned in this specification is a concept including an LED, a micro LED, and the like, and may be used interchangeably therewith.

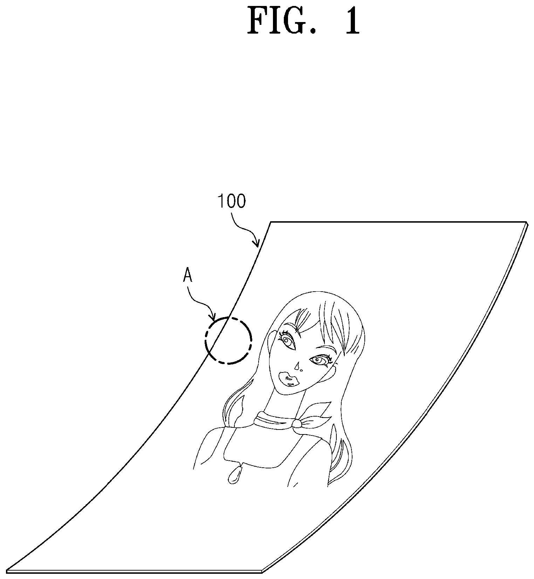

FIG. 1 is a conceptual view illustrating an embodiment of a display device using a semiconductor light emitting element according to the present disclosure.

As shown in FIG. 1, information processed by a controller (not shown) of a display device 100 may be displayed using a flexible display.

The flexible display may include, for example, a display that can be warped, bent, twisted, folded, or rolled by external force.

Furthermore, the flexible display may be, for example, a display manufactured on a thin and flexible substrate that can be warped, bent, folded, or rolled like paper while maintaining the display characteristics of a conventional flat panel display.

When the flexible display remains in an unbent state (e.g., a state having an infinite radius of curvature) (hereinafter referred to as a first state), the display area of the flexible display forms a flat surface. When the display in the first sate is changed to a bent state (e.g., a state having a finite radius of curvature) (hereinafter referred to as a second state) by external force, the display area may be a curved surface. As shown in FIG. 1, the information displayed in the second state may be visual information output on a curved surface. Such visual information may be implemented by independently controlling the light emission of sub-pixels arranged in a matrix form. The unit pixel may mean, for example, a minimum unit for implementing one color.

The unit pixel of the flexible display may be implemented by a semiconductor light emitting element. In the present disclosure, a light emitting diode (LED) is exemplified as a type of the semiconductor light emitting element configured to convert electric current into light. The LED may be formed in a small size, and may thus serve as a unit pixel even in the second state.

Hereinafter, a flexible display implemented using the LED will be described in more detail with reference to the drawings.

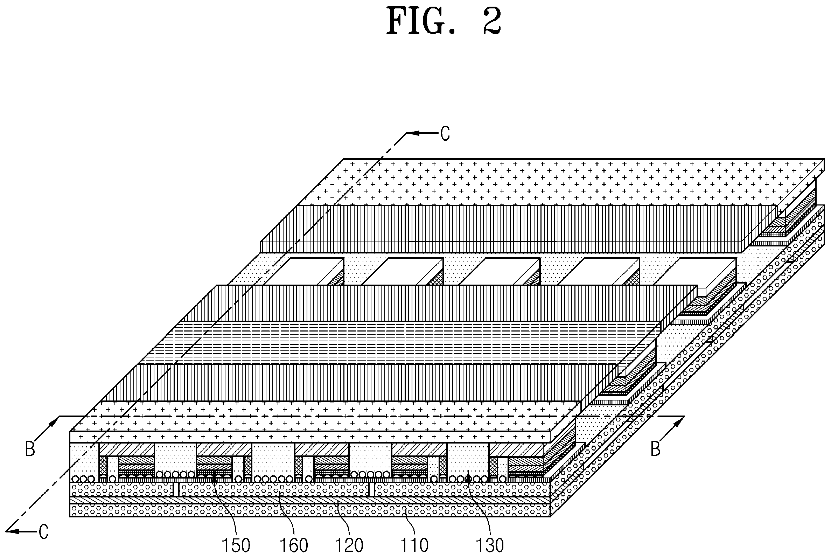

FIG. 2 is a partially enlarged view showing part A of FIG. 1.

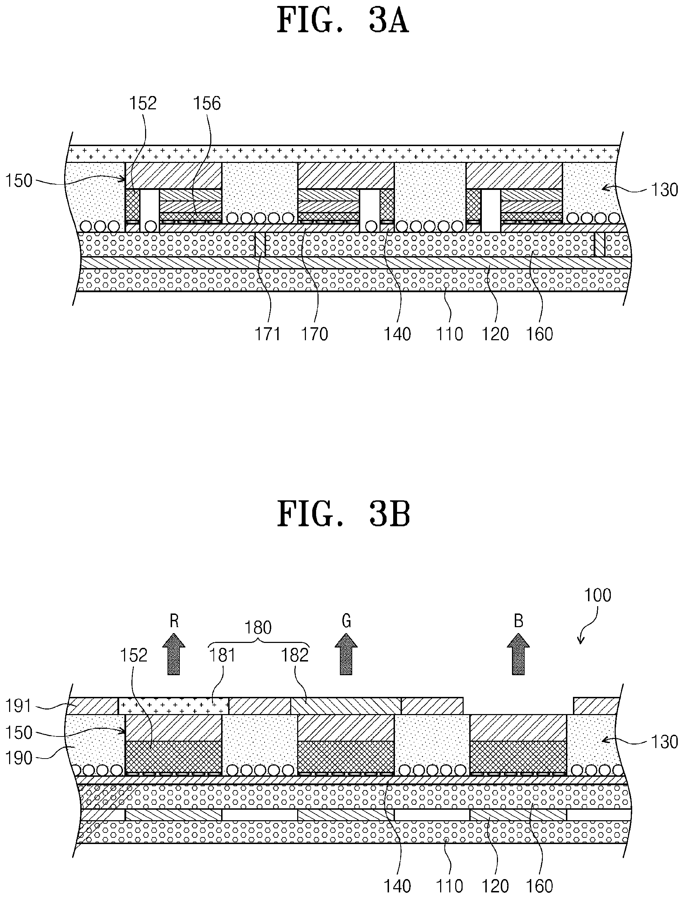

FIGS. 3A and 3B are cross-sectional views taken along lines B-B and C-C in FIG. 2.

As shown in FIGS. 2, 3A and 3B, the display device 100 using a passive matrix (PM) type semiconductor light emitting element is exemplified as the display device 100 using a semiconductor light emitting element. However, the examples described below are also applicable to an active matrix (AM) type semiconductor light emitting element.

The display device 100 shown in FIG. 1 may include a substrate 110, a first electrode 120, a conductive adhesive layer 130, a second electrode 140, and at least one semiconductor light emitting element 150, as shown in FIG. 2.

The substrate 110 may be a flexible substrate. For example, to implement a flexible display device, the substrate 110 may include glass or polyimide (PI). Any insulative and flexible material such as polyethylene naphthalate (PEN) or polyethylene terephthalate (PET) may be employed. In addition, the substrate 110 may be formed of either a transparent material or an opaque material.

The substrate 110 may be a wiring substrate on which the first electrode 120 is disposed. Thus, the first electrode 120 may be positioned on the substrate 110.

As shown in FIG. 3A, an insulating layer 160 may be disposed on the substrate 110 on which the first electrode 120 is positioned, and an auxiliary electrode 170 may be positioned on the insulating layer 160. In this case, a stack in which the insulating layer 160 is laminated on the substrate 110 may be a single wiring substrate. More specifically, the insulating layer 160 may be formed of an insulative and flexible material such as PI, PET, or PEN, and may be integrated with the substrate 110 to form a single substrate.

The auxiliary electrode 170, which is an electrode that electrically connects the first electrode 120 and the semiconductor light emitting element 150, is positioned on the insulating layer 160, and is disposed to correspond to the position of the first electrode 120. For example, the auxiliary electrode 170 may have a dot shape and may be electrically connected to the first electrode 120 by an electrode hole 171 formed through the insulating layer 160. The electrode hole 171 may be formed by filling a via hole with a conductive material.

As shown in FIGS. 2 or 3A, a conductive adhesive layer 130 may be formed on one surface of the insulating layer 160, but embodiments of the present disclosure are not limited thereto. For example, a layer performing a specific function may be formed between the insulating layer 160 and the conductive adhesive layer 130, or the conductive adhesive layer 130 may be disposed on the substrate 110 without the insulating layer 160. In a structure in which the conductive adhesive layer 130 is disposed on the substrate 110, the conductive adhesive layer 130 may serve as an insulating layer.

The conductive adhesive layer 130 may be a layer having adhesiveness and conductivity. For this purpose, a material having conductivity and a material having adhesiveness may be mixed in the conductive adhesive layer 130. In addition, the conductive adhesive layer 130 may have ductility, thereby providing making the display device flexible.

As an example, the conductive adhesive layer 130 may be an anisotropic conductive film (ACF), an anisotropic conductive paste, a solution containing conductive particles, or the like. The conductive adhesive layer 130 may be configured as a layer that allows electrical interconnection in the direction of the Z-axis extending through the thickness, but is electrically insulative in the horizontal X-Y direction. Accordingly, the conductive adhesive layer 130 may be referred to as a Z-axis conductive layer (hereinafter, referred to simply as a "conductive adhesive layer").

The ACF is a film in which an anisotropic conductive medium is mixed with an insulating base member. When the ACF is subjected to heat and pressure, only a specific portion thereof becomes conductive by the anisotropic conductive medium. Hereinafter, it will be described that heat and pressure are applied to the ACF. However, another method may be used to make the ACF partially conductive. The other method may be, for example, application of only one of the heat and pressure or UV curing.

In addition, the anisotropic conductive medium may be, for example, conductive balls or conductive particles. For example, the ACF may be a film in which conductive balls are mixed with an insulating base member. Thus, when heat and pressure are applied to the ACF, only a specific portion of the ACF is allowed to be conductive by the conductive balls. The ACF may contain a plurality of particles formed by coating the core of a conductive material with an insulating film made of a polymer material. In this case, as the insulating film is destroyed in a portion to which heat and pressure are applied, the portion is made to be conductive by the core. At this time, the cores may be deformed to form layers that contact each other in the thickness direction of the film. As a more specific example, heat and pressure are applied to the whole ACF, and an electrical connection in the Z-axis direction is partially formed by the height difference of a counterpart adhered by the ACF.

As another example, the ACF may contain a plurality of particles formed by coating an insulating core with a conductive material. In this case, as the conductive material is deformed (pressed) in a portion to which heat and pressure are applied, the portion is made to be conductive in the thickness direction of the film. As another example, the conductive material may be disposed through the insulating base member in the Z-axis direction to provide conductivity in the thickness direction of the film. In this case, the conductive material may have a pointed end.

The ACF may be a fixed array ACF in which conductive balls are inserted into one surface of the insulating base member. More specifically, the insulating base member may be formed of an adhesive material, and the conductive balls may be intensively disposed on the bottom portion of the insulating base member. Thus, when the base member is subjected to heat and pressure, it may be deformed together with the conductive balls, exhibiting conductivity in the vertical direction.

However, the present disclosure is not necessarily limited thereto, and the ACF may be formed by randomly mixing conductive balls in the insulating base member, or may be composed of a plurality of layers with conductive balls arranged on one of the layers (as a double- ACF).

The anisotropic conductive paste may be a combination of a paste and conductive balls, and may be a paste in which conductive balls are mixed with an insulating and adhesive base material. Also, the solution containing conductive particles may be a solution containing any conductive particles or nanoparticles.

Referring back to FIG. 3A, the second electrode 140 is positioned on the insulating layer 160 and spaced apart from the auxiliary electrode 170. That is, the conductive adhesive layer 130 is disposed on the insulating layer 160 having the auxiliary electrode 170 and the second electrode 140 positioned thereon.

After the conductive adhesive layer 130 is formed with the auxiliary electrode 170 and the second electrode 140 positioned on the insulating layer 160, the semiconductor light emitting element 150 is connected thereto in a flip-chip form by applying heat and pressure. Thereby, the semiconductor light emitting element 150 is electrically connected to the first electrode 120 and the second electrode 140.

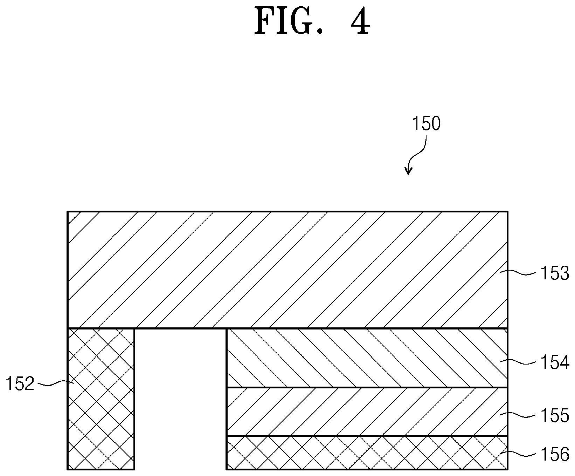

FIG. 4 is a conceptual view illustrating the flip-chip type semiconductor light emitting element of FIGS. 3A and 3B.

Referring to FIG. 4, the semiconductor light emitting element may be a flip chip-type light emitting device.

For example, the semiconductor light emitting element may include a p-type electrode 156, a p-type semiconductor layer 155 on which the p-type electrode 156 is formed, an active layer 154 formed on the p-type semiconductor layer 155, an n-type semiconductor layer 153 formed on the active layer 154, and an n-type electrode 152 disposed on the n-type semiconductor layer 153 and horizontally spaced apart from the p-type electrode 156. In this case, the p-type electrode 156 may be electrically connected to the auxiliary electrode 170, which is shown in FIGS. 3A and 3B, by the conductive adhesive layer 130, and the n-type electrode 152 may be electrically connected to the second electrode 140.

Referring back to FIGS. 2, 3A and 3B, the auxiliary electrode 170 may be elongated in one direction. Thus, one auxiliary electrode may be electrically connected to the plurality of semiconductor light emitting elements 150. For example, p-type electrodes of semiconductor light emitting elements on left and right sides of an auxiliary electrode may be electrically connected to one auxiliary electrode.

More specifically, the semiconductor light emitting element 150 may be press-fitted into the conductive adhesive layer 130 by heat and pressure. Thereby, only the portions of the semiconductor light emitting element 150 between the p-type electrode 156 and the auxiliary electrode 170 and between the n-type electrode 152 and the second electrode 140 may exhibit conductivity, and the other portions of the semiconductor light emitting element 150 do not exhibit conductivity as they are not press-fitted. In this way, the conductive adhesive layer 130 interconnects and electrically connects the semiconductor light emitting element 150 and the auxiliary electrode 170 and interconnects and electrically connects the semiconductor light emitting element 150 and the second electrode 140.

The plurality of semiconductor light emitting elements 150 may constitute a light emitting device array, and a phosphor conversion layer 180 may be formed on the light emitting device array.

The light emitting device array may include a plurality of semiconductor light emitting elements having different luminance values. Each semiconductor light emitting element 150 may constitute a unit pixel and may be electrically connected to the first electrode 120. For example, a plurality of first electrodes 120 may be provided, and the semiconductor light emitting elements may be arranged in, for example, several columns. The semiconductor light emitting elements in each column may be electrically connected to any one of the plurality of first electrodes.

In addition, since the semiconductor light emitting elements are connected in a flip-chip form, semiconductor light emitting elements grown on a transparent dielectric substrate may be used. The semiconductor light emitting elements may be, for example, nitride semiconductor light emitting elements. Since the semiconductor light emitting element 150 has excellent luminance, it may constitute an individual unit pixel even when it has a small size.

As shown in FIG. 3, a partition 190 may be formed between the semiconductor light emitting elements 150. In this case, the partition 190 may serve to separate individual unit pixels from each other, and may be integrated with the conductive adhesive layer 130. For example, by inserting the semiconductor light emitting element 150 into the ACF, the base member of the ACF may form the partition.

In addition, when the base member of the ACF is black, the partition 190 may have reflectance and increase contrast even without a separate black insulator.

As another example, a reflective partition may be separately provided as the partition 190. In this case, the partition 190 may include a black or white insulator depending on the purpose of the display device. When a partition including a white insulator is used, reflectivity may be increased. When a partition including a black insulator is used, it may have reflectance and increase contrast.

The phosphor conversion layer 180 may be positioned on the outer surface of the semiconductor light emitting element 150. For example, the semiconductor light emitting element 150 may be a blue semiconductor light emitting element that emits blue (B) light, and the phosphor conversion layer 180 may function to convert the blue (B) light into a color of a unit pixel. The phosphor conversion layer 180 may be a red phosphor 181 or a green phosphor 182 constituting an individual pixel.

That is, the red phosphor 181 capable of converting blue light into red (R) light may be laminated on a blue semiconductor light emitting element at a position of a unit pixel of red color, and the green phosphor 182 capable of converting blue light into green (G) light may be laminated on the blue semiconductor light emitting element at a position of a unit pixel of green color. Only the blue semiconductor light emitting element may be used alone in the portion constituting the unit pixel of blue color. In this case, unit pixels of red (R), green (G), and blue (B) may constitute one pixel. More specifically, a phosphor of one color may be laminated along each line of the first electrode 120. Accordingly, one line on the first electrode 120 may be an electrode for controlling one color. That is, red (R), green (G), and blue (B) may be sequentially disposed along the second electrode 140, thereby implementing a unit pixel.

However, embodiments of the present disclosure are not limited thereto. Unit pixels of red (R), green (G), and blue (B) may be implemented by combining the semiconductor light emitting element 150 and the quantum dot (QD) rather than using the phosphor.

Also, a black matrix 191 may be disposed between the phosphor conversion layers to improve contrast. That is, the black matrix 191 may improve contrast of light and darkness.

However, embodiments of the present disclosure are not limited thereto, and another structure may be applied to implement blue, red, and green colors.

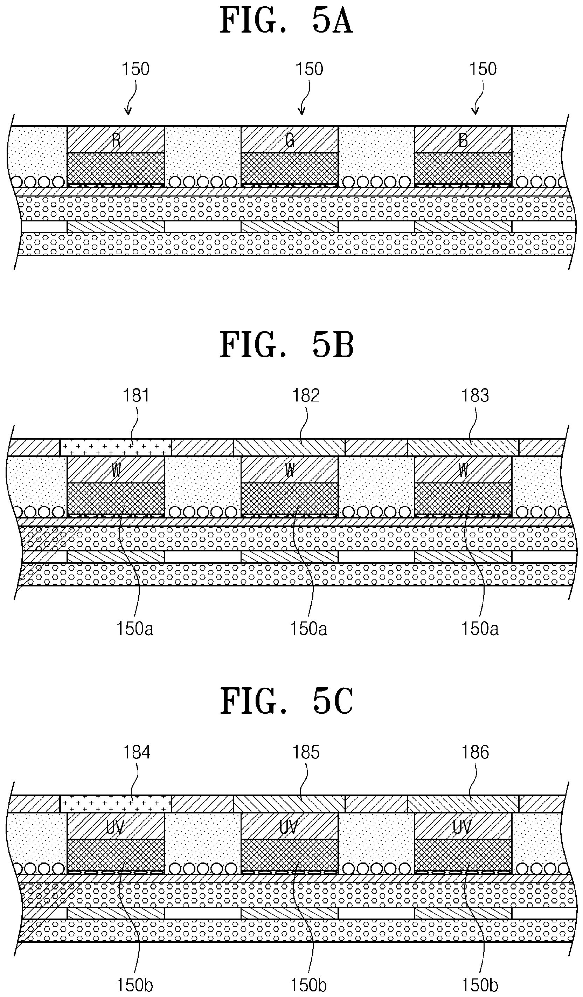

FIGS. 5A to 5C are conceptual views illustrating various examples of implementation of colors in relation to a flip-chip type semiconductor light emitting element.

Referring to FIG. 5A, each semiconductor light emitting element may be implemented as a high-power light emitting device emitting light of various colors including blue by using gallium nitride (GaN) as a main material and adding indium (In) and/or aluminum (Al).

In this case, each semiconductor light emitting element may be a red, green, or blue semiconductor light emitting element to form a unit pixel (sub-pixel). For example, red, green, and blue semiconductor light emitting elements R, G, and B may be alternately disposed, and unit pixels of red, green, and blue may constitute one pixel by the red, green and blue semiconductor light emitting elements. Thereby, a full-color display may be implemented.

Referring to FIG. 5B, the semiconductor light emitting element 150a may include a white light emitting device W having a yellow phosphor conversion layer, which is provided for each device. In this case, in order to form a unit pixel, a red phosphor conversion layer 181, a green phosphor conversion layer 182, and a blue phosphor conversion layer 183 may be disposed on the white light emitting device W. In addition, a unit pixel may be formed using a color filter repeating red, green, and blue on the white light emitting device W.

Referring to FIG. 5C, a red phosphor conversion layer 184, a green phosphor conversion layer 185, and a blue phosphor conversion layer 186 may be provided on a ultraviolet light emitting device. Not only visible light but also ultraviolet (UV) light may be used in the entire region of the semiconductor light emitting element. In an embodiment, UV may be used as an excitation source of the upper phosphor in the semiconductor light emitting element.

Referring back to this example, the semiconductor light emitting element is positioned on the conductive adhesive layer to constitute a unit pixel in the display device. Since the semiconductor light emitting element has excellent luminance, individual unit pixels may be configured despite even when the semiconductor light emitting element has a small size.

Regarding the size of such an individual semiconductor light emitting element, the length of each side of the device may be, for example, 80 µm or less, and the device may have a rectangular or square shape. When the semiconductor light emitting element has a rectangular shape, the size thereof may be less than or equal to 20 µm x 80 µm.

In addition, even when a square semiconductor light emitting element having a side length of 10 µm is used as a unit pixel, sufficient brightness to form a display device may be obtained.

Therefore, for example, in case of a rectangular pixel having a unit pixel size of 600µm x 300µm (i.e., one side by the other side), a distance of a semiconductor light emitting element becomes sufficiently long relatively.

Thus, in this case, it is able to implement a flexible display device having high image quality over HD image quality.

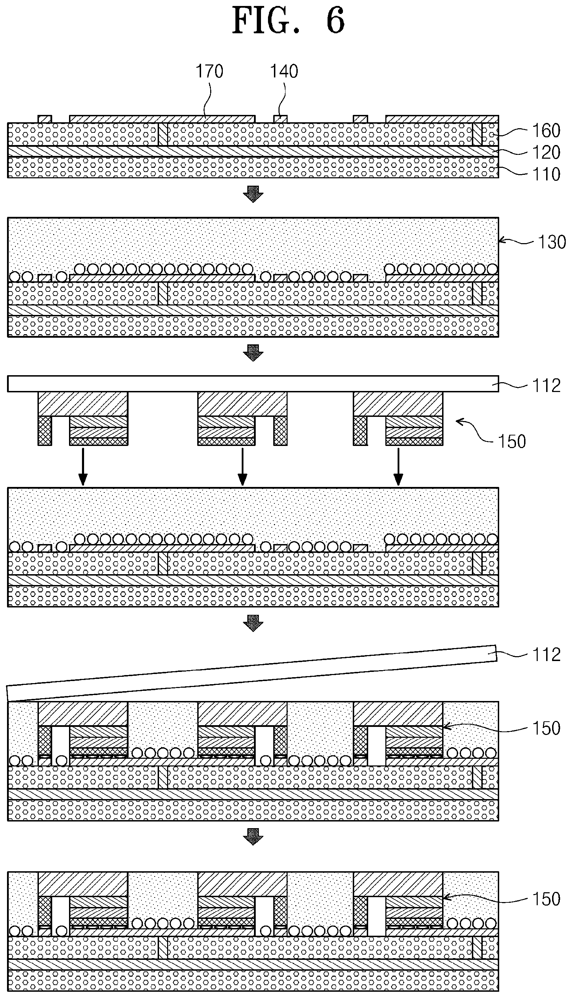

The above-described display device using the semiconductor light emitting element may be prepared by a new fabricating method. Such a fabricating method will be described with reference to FIG. 6 as follows.

FIG. 6 shows cross-sectional views of a method of fabricating a display device using a semiconductor light emitting element according to the present disclosure.

Referring to FIG. 6, first of all, a conductive adhesive layer 130 is formed on an insulating layer 160 located between an auxiliary electrode 170 and a second electrode 140. The insulating layer 160 is tacked on a wiring substrate 110. On the wiring substrate 110, a first electrode 120, the auxiliary electrode 170 and the second electrode 140 are disposed. In this case, the first electrode 120 and the second electrode 140 may be disposed in mutually orthogonal directions, respectively. In order to implement a flexible display device, the wiring substrate 110 and the insulating layer 160 may include glass or polyimide (PI) each.

For example, the conductive adhesive layer 130 may be implemented by an anisotropic conductive film. To this end, an anisotropic conductive film may be coated on the substrate on which the insulating layer 160 is located.

Subsequently, a temporary substrate 112, on which a plurality of semiconductor light emitting elements 150 configuring individual pixels are located to correspond to locations of the auxiliary electrode 170 and the second electrodes 140, is disposed in a manner that the semiconductor light emitting element 150 confronts the auxiliary electrode 170 and the second electrode 140.

In this regard, the temporary 112 substrate 112 is a growing substrate for growing the semiconductor light emitting element 150 and may include a sapphire or silicon substrate.

The semiconductor light emitting element is configured to have a space and size for configuring a display device when formed in unit of wafer, thereby being effectively used for the display device.

Subsequently, the wiring substrate 110 and the temporary substrate 112 are thermally compressed together. By the thermocompression, the wiring substrate 110 and the temporary substrate 112 are bonded together. Owing to the property of an anisotropic conductive film having conductivity by thermocompression, only a portion among the semiconductor light emitting element 150, the auxiliary electrode 170 and the second electrode 140 has conductivity, via which the electrodes and the semiconductor light emitting element 150 may be connected electrically. In this case, the semiconductor light emitting element 150 is inserted into the anisotropic conductive film, by which a partition may be formed between the semiconductor light emitting elements 150.

Then the temporary substrate 112 is removed. For example, the temporary substrate 112 may be removed using Laser Lift-Off (LLO) or Chemical Lift-Off (CLO).

Finally, by removing the temporary substrate 112, the semiconductor light emitting elements 150 exposed externally. If necessary, the wiring substrate 110 to which the semiconductor light emitting elements 150 are coupled may be coated with silicon oxide (SiOx) or the like to form a transparent insulating layer (not shared).

In addition, a step of forming a phosphor layer on one side of the semiconductor light emitting element 150 may be further included. For example, the semiconductor light emitting element 150 may include a blue semiconductor light emitting element emitting Blue (B) light, and a red or green phosphor for converting the blue (B) light into a color of a unit pixel may form a layer on one side of the blue semiconductor light emitting element.

The above-described fabricating method or structure of the display device using the semiconductor light emitting element may be modified into various forms. For example, the above-described display device may employ a vertical semiconductor light emitting element.

Furthermore, a modification or embodiment described in the following may use the same or similar reference numbers for the same or similar configurations of the former example and the former description may apply thereto.

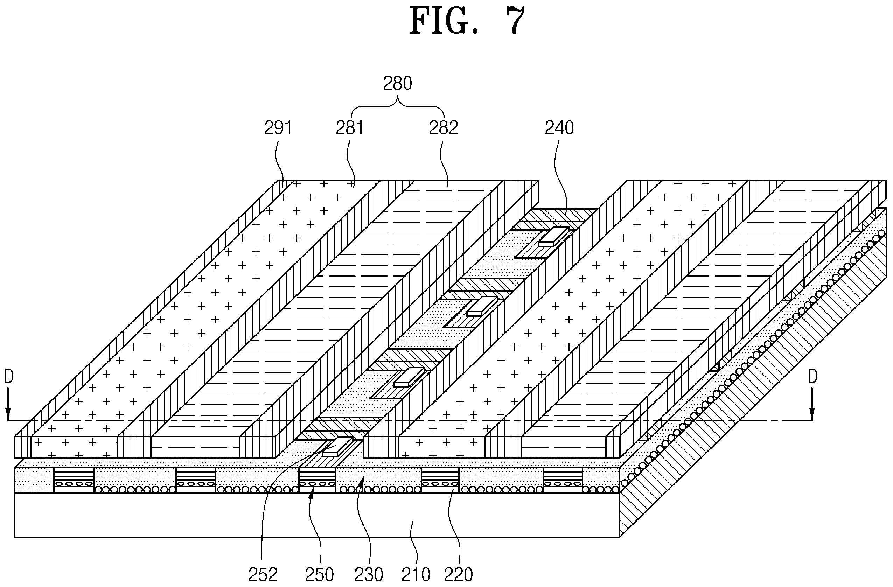

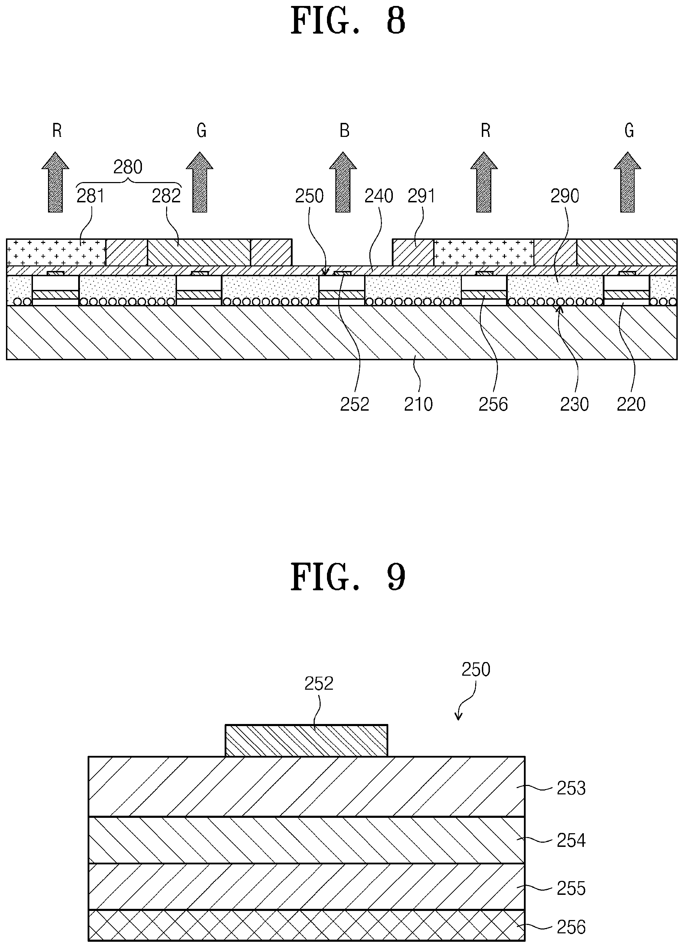

FIG. 7 is a perspective diagram of a display device using a semiconductor light emitting element according to another embodiment of the present disclosure, FIG. 8 is a cross-sectional diagram taken along a cutting line D-D shown in FIG. 8, and FIG. 9 is a conceptual diagram showing a vertical type semiconductor light emitting element shown in FIG. 8.

Referring to the present drawings, a display device may employ a vertical semiconductor light emitting device of a Passive Matrix (PM) type.

The display device includes a substrate 210, a first electrode 220, a conductive adhesive layer 230, a second electrode 240 and at least one semiconductor light emitting element 250.

The substrate 210 is a wiring substrate on which the first electrode 220 is disposed and may contain polyimide (PI) to implement a flexible display device. Besides, the substrate 210 may use any substance that is insulating and flexible.

The first electrode 210 is located on the substrate 210 and may be formed as a bar type electrode that is long in one direction The first electrode 220 may be configured to play a role as a data electrode.

The conductive adhesive layer 230 is formed on the substrate 210 where the first electrode 220 is located. Like a display device to which a light emitting device of a flip chip type is applied, the conductive adhesive layer 230 may include one of an Anisotropic Conductive Film (ACF), an anisotropic conductive paste, a conductive particle contained solution and the like. Yet, in the present embodiment, a case of implementing the conductive adhesive layer 230 with the anisotropic conductive film is exemplified.

After the conductive adhesive layer has been placed in the state that the first electrode 220 is located on the substrate 210, if the semiconductor light emitting element 250 is connected by applying heat and pressure thereto, the semiconductor light emitting element 250 is electrically connected to the first electrode 220. In doing so, the semiconductor light emitting element 250 is preferably disposed to be located on the first electrode 220.

If heat and pressure is applied to an anisotropic conductive film, as described above, since the anisotropic conductive film has conductivity partially in a thickness direction, the electrical connection is established. Therefore, the anisotropic conductive film is partitioned into a conductive portion and a non-conductive portion.

Furthermore, since the anisotropic conductive film contains an adhesive component, the conductive adhesive layer 230 implements mechanical coupling between the semiconductor light emitting element 250 and the first electrode 220 as well as mechanical connection.

Thus, the semiconductor light emitting element 250 is located on the conductive adhesive layer 230, via which an individual pixel is configured in the display device. As the semiconductor light emitting element 250 has excellent luminance, an individual unit pixel may be configured in small size as well. Regarding a size of the individual semiconductor light emitting element 250, a length of one side may be equal to or smaller than 80 µm for example and the individual semiconductor light emitting element 250 may include a rectangular or square element. For example, the rectangular element may have a size equal to or smaller than 20µm X 80µm.

The semiconductor light emitting element 250 may have a vertical structure.

Among the vertical type semiconductor light emitting elements, a plurality of second electrodes 240 respectively and electrically connected to the vertical type semiconductor light emitting elements 250 are located in a manner of being disposed in a direction crossing with a length direction of the first electrode 220.

Referring to FIG. 9, the vertical type semiconductor light emitting element 250 includes a p-type electrode 256, a p-type semiconductor layer 255 formed on the p-type electrode 256, an active layer 254 formed on the p-type semiconductor layer 255, an n-type semiconductor layer 253 formed on the active layer 254, and an n-type electrode 252 formed on then-type semiconductor layer 253. In this case, the p-type electrode 256 located on a bottom side may be electrically connected to the first electrode 220 by the conductive adhesive layer 230, and the n-type electrode 252 located on a top side may be electrically connected to a second electrode 240 described later. Since such a vertical type semiconductor light emitting element 250 can dispose the electrodes at top and bottom, it is considerably advantageous in reducing a chip size.

Referring to FIG. 8 again, a phosphor layer 280 may formed on one side of the semiconductor light emitting element 250. For example, the semiconductor light emitting element 250 may include a blue semiconductor light emitting element 251 emitting blue (B) light, and a phosphor layer 280 for converting the blue (B) light into a color of a unit pixel may be provided. In this regard, the phosphor layer 280 may include a red phosphor 281 and a green phosphor 282 configuring an individual pixel.

Namely, at a location of configuring a red unit pixel, the red phosphor 281 capable of converting blue light into red (R) light may be stacked on a blue semiconductor light emitting element. At a location of configuring a green unit pixel, the green phosphor 282 capable of converting blue light into green (G) light may be stacked on the blue semiconductor light emitting element. Moreover, the blue semiconductor light emitting element may be singly usable for a portion that configures a blue unit pixel. In this case, the unit pixels of red (R), green (G) and blue (B) may configure a single pixel.

Yet, the present disclosure is non-limited by the above description. In a display device to which a light emitting element of a flip chip type is applied, as described above, a different structure for implementing blue, red and green may be applicable.

Regarding the present embodiment again, the second electrode 240 is located between the semiconductor light emitting elements 250 and connected to the semiconductor light emitting elements electrically. For example, the semiconductor light emitting elements 250 are disposed in a plurality of columns, and the second electrode 240 may be located between the columns of the semiconductor light emitting elements 250.

Since a distance between the semiconductor light emitting elements 250 configuring the individual pixel is sufficiently long, the second electrode 240 may be located between the semiconductor light emitting elements 250.

The second electrode 240 may be formed as an electrode of a bar type that is long in one direction and disposed in a direction vertical to the first electrode.

In addition, the second electrode 240 and the semiconductor light emitting element 250 may be electrically connected to each other by a connecting electrode protruding from the second electrode 240. Particularly, the connecting electrode may include a n-type electrode of the semiconductor light emitting element 250. For example, the n-type electrode is formed as an ohmic electrode for ohmic contact, and the second electrode covers at least one portion of the ohmic electrode by printing or deposition. Thus, the second electrode 240 and the n-type electrode of the semiconductor light emitting element 250 may be electrically connected to each other.

Referring to FIG. 8 again, the second electrode 240 may be located on the conductive adhesive layer 230. In some cases, a transparent insulating layer (not shown) containing silicon oxide (SiOx) and the like may be formed on the substrate 210 having the semiconductor light emitting element 250 formed thereon. If the second electrode 240 is placed after the transparent insulating layer has been formed, the second electrode 240 is located on the transparent insulating layer. Alternatively, the second electrode 240 may be formed in a manner of being spaced apart from the conductive adhesive layer 230 or the transparent insulating layer.

If a transparent electrode of Indium Tin Oxide (ITO) or the like is sued to place the second electrode 240 on the semiconductor light emitting element 250, there is a problem that ITO substance has poor adhesiveness to an n-type semiconductor layer. Therefore, according to the present disclosure, as the second electrode 240 is placed between the semiconductor light emitting elements 250, it is advantageous in that a transparent electrode of ITO is not used. Thus, light extraction efficiency can be improved using a conductive substance having good adhesiveness to an n-type semiconductor layer as a horizontal electrode without restriction on transparent substance selection.

Referring to FIG. 8 again, a partition 290 may be located between the semiconductor light emitting elements 250. Namely, in order to isolate the semiconductor light emitting element 250 configuring the individual pixel, the partition 290 may be disposed between the vertical type semiconductor light emitting elements 250. In this case, the partition 290 may play a role in separating the individual unit pixels from each other and be formed with the conductive adhesive layer 230 as an integral part. For example, by inserting the semiconductor light emitting element 250 in an anisotropic conductive film, a base member of the anisotropic conductive film may form the partition.

In addition, if the base member of the anisotropic conductive film is black, the partition 290 may have reflective property as well as a contrast ratio may be increased, without a separate block insulator.

For another example, a reflective partition may be separately provided as the partition 190. The partition 290 may include a black or white insulator depending on the purpose of the display device.

In case that the second electrode 240 is located right onto the conductive adhesive layer 230 between the semiconductor light emitting elements 250, the partition 290 may be located between the vertical type semiconductor light emitting element 250 and the second electrode 240 each. Therefore, an individual unit pixel may be configured using the semiconductor light emitting element 250. Since a distance between the semiconductor light emitting elements 250 is sufficiently long, the second electrode 240 can be placed between the semiconductor light emitting elements 250. And, it may bring an effect of implementing a flexible display device having HD image quality.

In addition, as shown in FIG. 8, a black matrix 291 may be disposed between the respective phosphors for the contrast ratio improvement. Namely, the black matrix 291 may improve the contrast between light and shade.

In a display device using the semiconductor light emitting element according to the present disclosure described above, the semiconductor light emitting element is disposed on the wiring substrate in a flip-chip type and used as an individual pixel.

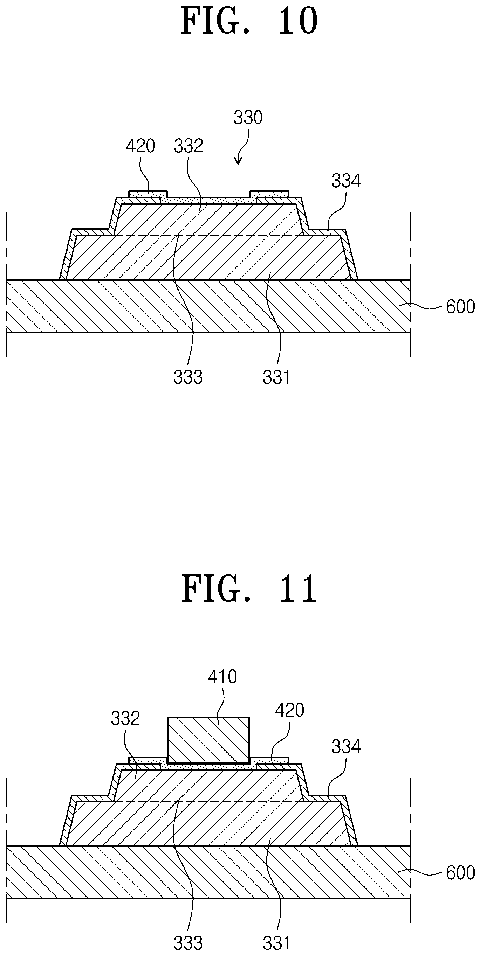

FIGS. 10 to 14 are cross-sectional views showing some steps of a manufacturing process of a display device including a light emitting element according to an embodiment of the present disclosure.

Referring to FIG. 10, a light emitting element 330 according to an embodiment of the present disclosure may be formed on a growing substrate 600 and may be in a state of being partitioned as an individual light emitting element 330.

Such an individual light emitting element 330 may include a semiconductor layer including a first conductivity-type semiconductor layer 331, a second conductivity-type semiconductor layer 332, and an active layer 333 disposed between the first conductivity-type semiconductor layer 331 and the second conductivity-type semiconductor layer 332. A horizontal cross-sectional shape of such a semiconductor layer may be one of a circular shape, an elliptical shape, and a polygonal shape.

For example, the first conductivity type may be an n-type. Accordingly, the second conductivity type may be a p-type. Hereinafter, an embodiment of the present disclosure will be described focusing on an example in which the first conductivity type is an n-type and the second conductivity type is a p-type. For example, the first conductivity-type semiconductor layer 331 may be an n-type semiconductor layer, and the second conductivity-type semiconductor layer 332 may be a p-type semiconductor layer. However, embodiments of the present disclosure are not limited thereto. That is, as another example, the first conductivity-type semiconductor layer 331 may be a p-type semiconductor layer, and the second conductivity-type semiconductor layer 332 may be an n-type semiconductor layer.

For example, the light emitting element 330 may include a passivation layer 334 for protecting an outer surface thereof from an electrical impact. Such a passivation layer 334 may be partially removed during an assembly process or a wiring connection process.

A sacrificial layer 420 may be formed on a top surface of the light emitting element 330. The sacrificial layer 420 may include, for example, a metal thin film made of aluminum (Al) or the like. For example, the sacrificial layer 420 may be formed as an aluminum thin film.

Referring to FIG. 10, the sacrificial layer 420 may be positioned on the top surface of the light emitting element 330. For example, a width or a diameter of the sacrificial layer 420 may be equal to or smaller than a width or a diameter of the top surface of the light emitting element 330.

For example, when the light emitting element 330 has a cylindrical shape, the diameter of the sacrificial layer 420 may be equal to or smaller than the diameter of the top surface of the light emitting element 330.

Such a sacrificial layer 420 may be in contact with the passivation layer 334 positioned on the top surface of the light emitting element 330 and the second conductivity-type semiconductor layer 332 exposed through the top surface of the light emitting element 330. Such a sacrificial layer 420 may have a stepped shape at a portion in contact with the second conductivity-type semiconductor layer 332.

Referring to FIG. 11, an adhesive layer 410 may be formed on the sacrificial layer 420. Such an adhesive layer 410 may include an adhesive resin material. For example, the adhesive layer 410 may include a photo-resist material.

For example, the width or the diameter of the sacrificial layer 420 may be greater than a width or a diameter of the adhesive layer 410. For example, the adhesive layer 410 may be formed in contact with the portion of the sacrificial layer 420 forming the stepped shape.

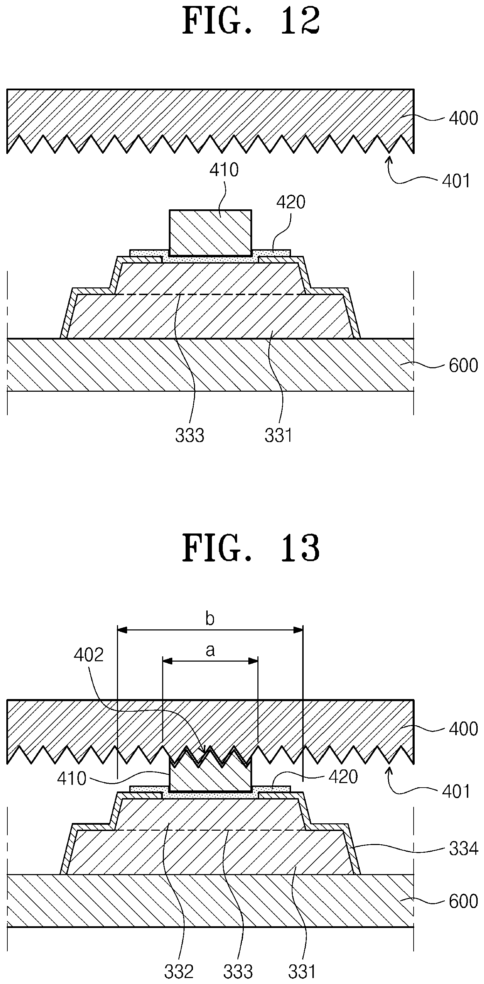

Referring to FIG. 12, the adhesive layer 410 may be attached to a transfer substrate 400.

In an exemplary embodiment, the transfer substrate 400 may be a sapphire substrate. A rough surface may be formed on a first surface 401 of the transfer substrate 400. For example, such a rough surface may be a surface obtained by wet-etching the first surface 401 of the sapphire substrate. By such etching, a fine pattern having a hexagonal pyramid or conical shape may be formed on the first surface 401 of the sapphire substrate.

In an exemplary embodiment, the rough surface may include an uneven pattern increasing a surface area of the first surface 401 of the transfer substrate 400. Such an uneven pattern may increase the surface area of the first surface 401 of the transfer substrate 400 to which the adhesive layer 410 is attached to enhance the adhesive force of the adhesive layer 410.

Such a fine pattern or uneven pattern may be formed on the entire first surface 401. Therefore, the fine pattern or the uneven pattern and the first surface 401 will be described using the same reference numeral.

FIG. 13 shows a state in which the light emitting element 330 is attached to the fine pattern or uneven pattern 401 formed on the first surface 401 of the transfer substrate 400 by the adhesive layer 410. As described above, the sacrificial layer 420 may be positioned between the adhesive layer 410 and the light emitting element 330.

As described above, the width or the diameter of the sacrificial layer 420 may be equal to or smaller than a width or diameter b of the top surface of the light emitting element 330.

In addition, a width or diameter a of the adhesive layer 410 may be equal to or smaller than the width or diameter b of the top surface of the light emitting element 330.

As such, the adhesive layer 410 may be adhered to an adhesive portion 402 defining a partial area on the first surface 401 of the transfer substrate 400.

Because the light emitting element 330 is attached, via the adhesive layer 410, to the fine pattern or uneven pattern 401 formed on the first surface 401 of the transfer substrate 400 to greatly increase the surface area of the first surface 401, even when the adhesive portion 402 of the adhesive layer 410 is reduced, sufficient adhesive force may be secured. Accordingly, an alignment margin between the adhesive layer 410 and the light emitting element 330 may be more easily secured. This will be described in detail later.

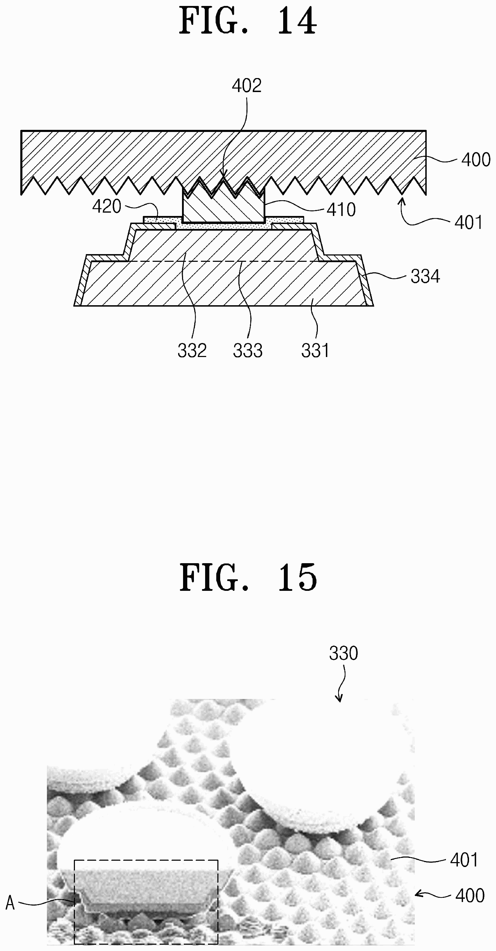

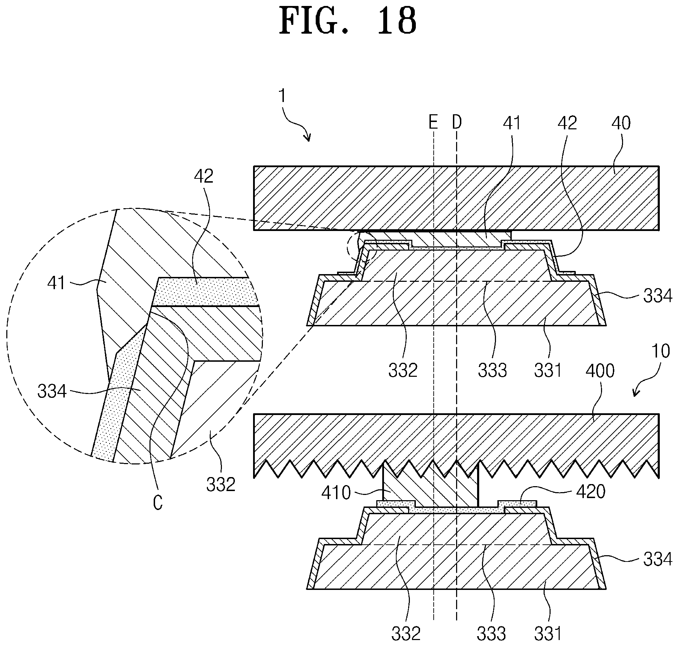

Thereafter, as shown in FIG. 14, when the growing substrate 600 is removed from the light emitting element 330, a transfer substrate assembly 10 (see FIG. 18) may be formed. In one example, in some cases, the state shown in FIG. 13, in which the growing substrate 600 is not removed, may be referred to as the transfer substrate assembly.

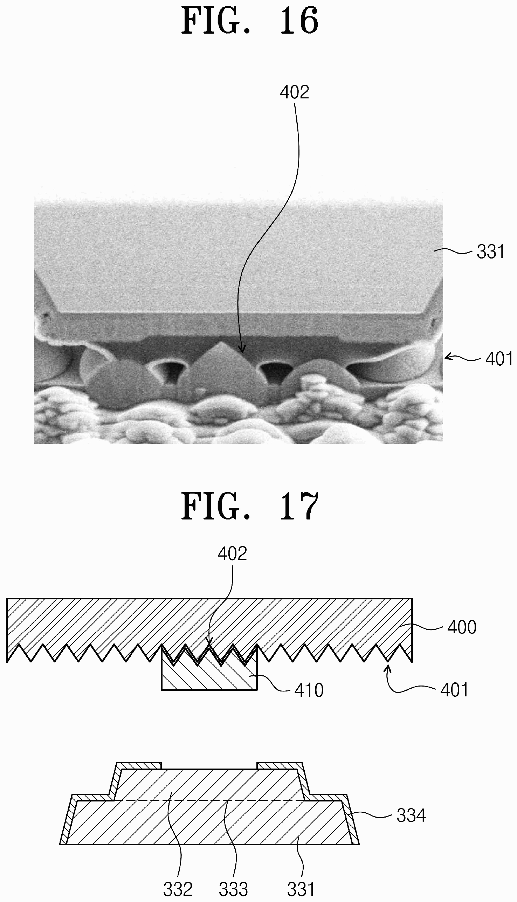

FIG. 15 is a photograph showing a portion of a transfer substrate assembly according to an embodiment of the present disclosure. FIG. 16 is an enlarged photograph of a portion A in FIG. 15.

FIG. 15 is a scanning electron microscope (SEM) image showing a state in which the individual light emitting elements 330 are stably attached to the first surface 401 of the transfer substrate 400. Referring to FIG. 15, the fine pattern or uneven pattern 401 having the conical or hexagonal pyramid shape is distributed to form the rough surface on the transfer substrate 400, and the individual light emitting elements 330 are attached to such a rough surface.

Referring to FIG. 16, which is the enlarged photograph, a state in which, by the fine pattern or uneven pattern 401, the light emitting element 330 is adhered to the adhesive portion 402 such that the first conductivity-type semiconductor layer 331 is oriented to face the fine pattern or uneven pattern 401 is illustrated.

FIG. 17 is a cross-sectional view illustrating a state in which an individual light emitting element is dispersed during a process of manufacturing a display device including the light emitting elements according to an embodiment of the present disclosure.

As an exemplary embodiment, in the light emitting element 330 according to an embodiment of the present disclosure, an electrode may be formed on a surface from which the growing substrate 600 is removed. Such an electrode may include a magnetic layer (not shown). On the contrary, the magnetic layer may be formed separately from the electrode.

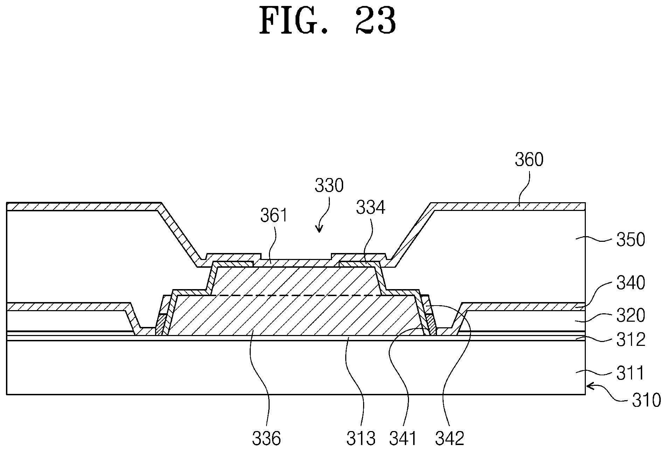

In order to be used as a sub-pixel of the display device, the light emitting element 330 may be assembled to a wiring substrate 310 (see FIG. 23) or a separate assembly board (not shown) using magnetic force. For example, the light emitting element 330 may be dispersed into a fluid and then be assembled using magnetic force in the fluid. Accordingly, the magnetic layer may help the process of assembling the light emitting element 330 using magnetic force.

For example, the light emitting elements 330 may be dispersed into the fluid by disposing the transfer substrate assembly 10 in the fluid and then removing the respective sacrificial layers 420 of the elements 330. For example, the fluid may include a liquid capable of etching metal used as the sacrificial layer 420, and thus the sacrificial layer 420 may be removed. As described above, because the size of the sacrificial layer 420 may be reduced, the time for removing the sacrificial layer 420 may also be reduced. Accordingly, the process time may be reduced.

FIG. 18 is a view for illustrating respective alignment margins of a transfer substrate assembly according to a comparative example and a transfer substrate assembly according to an embodiment of the present disclosure.

Referring to FIG. 18, as a comparative example, a transfer substrate assembly 1 that transfers the light emitting element 330 using a general transfer substrate 40 having no rough surface will be described in comparison with the transfer substrate assembly 10 according to an embodiment of the present disclosure.

From the viewpoint of the manufacturing process, the characteristics of the transfer substrate assembly may be considered based on two criteria.

First, considering a throughput of the light emitting element (chip) dispersion process, in order to increase productivity in the dispersion process of the light emitting element 330 bonded to the transfer substrate (donor substrate) 400, the area of the sacrificial layer 420 may be reduced and the area of the adhesive portion 402 may be reduced, thereby reducing the time required to disperse the light emitting element 330 in the fluid by removing the sacrificial layer 420.

In order to reduce the dispersion time of the light emitting element 330, it may be required to reduce the thickness and size of the sacrificial layer 420 and the size of the adhesive layer 410. Compared to the comparative example, according to the embodiment of the present disclosure, the thickness of the sacrificial layer 420 may be reduced. The width (diameter) of the sacrificial layer 420 may be reduced. In addition, the width (diameter) of the adhesive layer 410 may be reduced.

On the other hand, considering the dispersion process, by attaching the adhesive layer 410 to the transfer substrate 400 having the rough surface, the size of the adhesive layer 410 may be reduced, and accordingly, an alignment margin may be further secured.

As the size of the light emitting element 330 becomes extremely small, it may be required to reduce the size of the adhesive layer 410 in order to secure a process margin. In general, the adhesive force of the adhesive layer 410 may be reduced accordingly. However, according to the embodiment of the present disclosure, the adhesive area is greatly increased by the uneven pattern 401 of the transfer substrate 400, so that the adhesive force of the adhesive layer 410 may not decrease or may rather increase.

In the transfer substrate assembly 1 according to the comparative example, when the thickness of a sacrificial layer 42 is small, a possibility of disconnection C of the sacrificial layer 42 at an edge of a MESA structure of the second conductivity-type semiconductor layer 332 of the light emitting element 330 increases.

The adhesive layer 41 should be aligned along an alignment line D and attached to the transfer substrate 40, but when the alignment of the adhesive layer 41 moves to a portion indicated by E, the adhesive layer 41 and the sacrificial layer 42 may be bonded to each other in a region where the disconnection C occurs in the sacrificial layer 42. Accordingly, a possibility that the light emitting element 330 is not dispersed as desired may increase. For example, in the structure according to the comparative example, the contact area may be reduced as a result of an alignment error.

For example, when the thickness of the sacrificial layer 42 is reduced in the assembly structure as in the comparative example to reduce the dispersion time, the adhesive layer 41 may be locally in direct contact with the chip of the light emitting element 330 due to a coverage problem of deposition equipment at the edge of the MESA region, and thus the light emitting element 330 may not be dispersed even when the sacrificial layer 42 is removed.

However, according to the embodiment of the present disclosure, the above problems may be solved.

As the size of the light emitting element 330 becomes smaller, the size of the MESA decreases, and thus the alignment margin of the adhesive layer 410 decreases. However, according to the embodiment of the present disclosure, because the size of the adhesive layer 410 may be reduced, a sufficient alignment margin may be secured.

For example, even when the alignment line varies (D -> E), the adhesive area may be the same. Accordingly, the adhesive layer 410 may have sufficient adhesive strength to attach the light emitting element 330 and the transfer substrate 400 to each other. In addition, a problem in dispersion may not occur due to such an alignment error. Further, the area of the sacrificial layer 420 may also be reduced.

According to the embodiment of the present disclosure, the size of the pattern of the contact layer 410 may be reduced, and accordingly, the size and thickness of the sacrificial layer 420 may be reduced. Accordingly, the time for etching the sacrificial layer 420 may be reduced, and the dispersion time of the light emitting element 330 may be reduced. Accordingly, productivity may be improved.

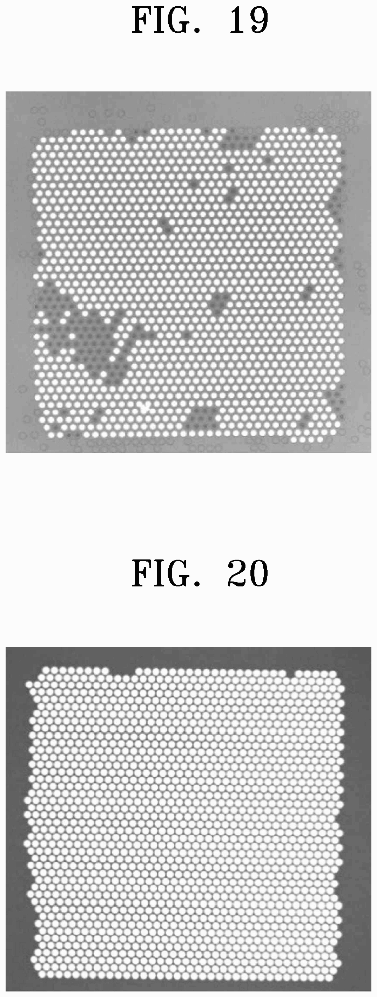

FIG. 19 is a photograph showing a state in which light emitting elements are bonded to a transfer substrate according to a comparative example. FIG. 20 is a photograph showing a state in which light emitting elements are bonded to a transfer substrate according to an embodiment of the present disclosure.

In the process according to the comparative example, adhesive force between the transfer substrate 40 and the chip of the light emitting element 330 is insufficient, so that chip loss may occur as shown in the photograph.

That is, when the growing substrate on which the light emitting elements 330 are formed is bonded to the transfer substrate 40 having the flat surface, bonding force may not be sufficient, and thus chip loss may occur.

FIG. 19 shows a state in which light emitting element chips are removed without being bonded to the transfer substrate in some regions. This may cause loss and yield reduction of the light emitting elements.

On the other hand, according to the embodiment of the present disclosure, as shown in FIG. 20, it may be seen that the light emitting elements 330 are attached to the transfer substrate 400 with sufficient adhesive force, and thus chip loss does not occur.

As described above, in order to disperse the chips of the light emitting elements 330 generally using the micro LEDs as individual chips in a fluid, the growing substrate 600 is bonded to the transfer substrate (donor substrate) 400 and then the dispersion process is performed.

In this regard, chip loss may be prevented after the dispersion process and the assembly process only when attaching force is equal to or greater than an appropriate magnitude in the bonding process between the growing substrate 600 and the transfer substrate 400.

According to the embodiment of the present disclosure, chip loss may be reduced or prevented by increasing attaching force during the bonding process between the growing substrate 600 and the transfer substrate 400.

In order to increase adhesive force between the growing substrate 600 and the transfer substrate 400, bonding force of a photoresist material used for the adhesive layer 410 may be important. Factors that may increase bonding force of such a photoresist material may include improvement of material characteristics of the photoresist, an increase in the bonding area, and the like.

In terms of the increase in the bonding area, when a general transfer substrate having a flat surface is used, there is a limit to adhesive force between the growing substrate 600 and the transfer substrate 400.

According to the embodiment of the present disclosure, by applying the uneven pattern 401 to the transfer substrate 400, stress caused by pressure during the process may be reduced, and the bonding process area may be increased, so that the light emitting element chip may be stably bonded to the transfer substrate.

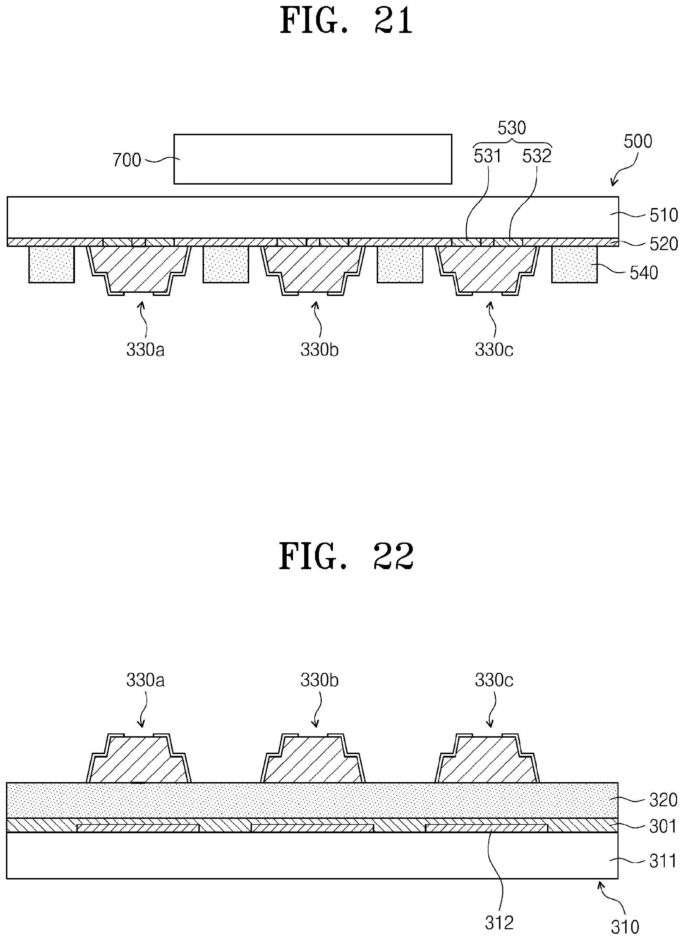

FIGS. 21 and 22 are schematic views showing a manufacturing process of a display device according to an embodiment of the present disclosure.

Hereinafter, as an exemplary embodiment, a process in which the light emitting element 330 is dispersed in the fluid and then assembled to the wiring substrate 310 will be briefly described.

Referring toFIGS. 21, light emitting elements 330a, 330b, and 330c may be assembled on an assembly substrate 500.

In the assembly substrate 500, an assembly electrode 531 and 532; 530 may be disposed on a base substrate 510 together with an insulating layer 520. For example, a partition wall 540 defining assembly spaces in which the light emitting elements 330a, 330b, and 330c are assembled may be disposed on the insulating layer 520.

As described above, the light emitting elements 330a, 330b, and 330c may be assembled on the assembly substrate 500 using a magnet 700. In this regard, as described above, the light emitting elements 330a, 330b, and 330c may include a magnetic layer. The assembly process of such light emitting elements 330a, 330b, and 330c may be performed in a fluid.

As mentioned above, in order to impart vertical selectivity of the light emitting elements 330a, 330b, and 330c, it may be advantageous that the lower contact area of the elements is greater than the upper contact area thereof. To this end, for example, the contact area may be adjusted through a patterning and/or etching process of a passivation layer of the light emitting elements 330a, 330b, and 330c. Alternatively, as another example, the upper second conductivity-type semiconductor layer 332 may be partially etched to cause a difference in the upper and lower contact areas.

Here, the light emitting elements 330a, 330b, and 330c may include a red light emitting element 330a, a green light emitting element 330b, and a blue light emitting element 330c. Although the three light emitting elements are shown in FIGS. 21 and the following drawings, more light emitting elements 330a, 330b, and 330c may be self-assembled using a magnet 500.

The light emitting elements 330a, 330b, and 330c assembled on the assembly substrate 500 using the magnet 700 may be fixed by a dielectrophoresis (DEP) force as an electric field is applied to the assembly electrode 530.

Referring to FIG. 22, the light emitting elements 330a, 330b, and 330c assembled on the assembly substrate 500 may be transferred onto the wiring substrate 310.

In an exemplary embodiment, the light emitting elements 330a, 330b, and 330c assembled on the assembly substrate 500 may be transferred onto the wiring substrate 310 after being transferred onto a temporary substrate.

The wiring substrate 310 may include a first electrode 312 disposed on a substrate 311. The first electrode 312 may be covered by the insulating layer 301.

A seating layer 320 may be located on the insulating layer 301. Such a seating layer 320 may have adhesive force for fixing the light emitting element 330 in the assembly process of the light emitting element 330, and may be cured later to support the light emitting elements 330a, 330b, and 330c.

FIG. 23 is a cross-sectional view showing a display device according to an embodiment of the present disclosure.

Referring to FIG. 23, in the display device according to an embodiment of the present disclosure, the light emitting element 330 forming a unit sub-pixel may be disposed on the wiring substrate 310 on which the first electrode 312 is disposed. The wiring substrate 310 may include the first electrode 312 disposed on the substrate 311.

In the wiring substrate 310, multiple first electrodes 312 may be positioned on the substrate 311. Such a first electrode 312 may be used as a wiring electrode. The first electrodes 312 may be partitioned and positioned on the substrate 311. Here, the wiring electrode may be used as a data electrode (pixel electrode) or a scan electrode (common electrode).

Although one light emitting element 330 is shown in FIG. 23, the light emitting elements 330 respectively forming three unit sub-pixels may constitute a unit pixel. In this regard, the light emitting elements 330 may include a red light emitting element that emits red light, a green light emitting element that emits green light, and a blue light emitting element that emits blue light. Such unit pixels may be repeatedly provided on the wiring substrate 310.

Although not shown, the first electrode 312 disposed on the wiring substrate 310 may be connected to a TFT layer provided with a thin film transistor (TFT). The data electrode (pixel electrode) may be connected to such a TFT layer. A detailed description thereof will be omitted.

A partition wall 320 for defining an assembly hole of the light emitting element may be positioned between the wiring substrate 310 and the light emitting element 330.

In an exemplary embodiment, at least one of the top surface and a bottom surface of the light emitting element 330 may have a circular shape. For example, the light emitting element 330 may have a cylindrical shape or a truncated cone shape.

In order to provide vertical selectivity when assembling the light emitting element 330, the lower area of the light emitting element 330 may be greater than the upper area thereof.

In addition, the display device 300 may include a first connection electrode 340 that electrically connects the first electrode 312 with one side of the light emitting element 330. Such a first connection electrode 340 may be made of metal having high electrical conductivity, such as Al, Mo, Cu, Ag, or Pt.

In an exemplary embodiment, one side of the light emitting element 330 to which the first connection electrode 340 is connected may be a side surface of the light emitting layer 333 of the light emitting element 330. For example, the first connection electrode 340 may be laterally connected to a surface formed by the light emitting layer 333 of the light emitting element 330. Such a first connection electrode 340 may extend to a side surface of the first conductivity-type semiconductor layer 331 of the light emitting element 330 to form a side surface 342, thereby being electrically connected to the first conductivity-type semiconductor layer 331.

As described above, the first connection electrode 340 may include the side surface 342 positioned on the side surface of the light emitting element 330 and a bottom surface 343 positioned on a top surface of the seating layer 320.

Referring to FIG. 23, the first connection electrode 340 may be provided on both sides of the light emitting element 330. In some cases, the first connection electrode 340 may be provided to cover the side surface of the light emitting element 330.

The passivation layer 334 may be positioned outside a portion of the side surface of the light emitting element 330 to which the first connection electrode 340 is connected. As described above, the passivation layer 334 may be positioned on an outer side of the light emitting element 330, and the first connection electrode 340 may be positioned beneath the passivation layer 334. Such a passivation layer 334 may protect an outer surface of the light emitting element 330.

A planarization layer 350 may be positioned on side portions of the first connection electrode 340 and the light emitting element 330. The planarization layer 350 may cover the first connection electrode 340 and the light emitting element 330. An upper side of the planarization layer 350 may have a vertical level that is flush with an upper side of the light emitting element 330, or a vertical level higher than that of the upper side of the light emitting element 330.

In this regard, the second conductivity-type semiconductor layer 332 in the upper side of the light emitting element 330 may be exposed. For example, even when the upper side of the planarization layer 350 has a vertical level higher than that of the upper side of the light emitting element 330, the second conductivity-type semiconductor layer 332 of the light emitting element 330 may be exposed.

In addition, a second connection electrode 361 positioned on the planarization layer 350 and electrically connected to an opposite side of the light emitting element 330 may be provided. For example, such a second connection electrode 361 may include a transparent electrode such as ITO. Accordingly, light emitted from the light emitting element 330 may pass through the second connection electrode 361 and be emitted to the outside.

As described above, the first electrode 312 and the second electrode 360 may be used as wiring electrodes. For example, the first electrode 312 may function as the data electrode (the pixel electrode), and the second electrode 360 may function as the scan electrode (the common electrode).

Referring to FIG. 23, the second connection electrode 361 may be partially located on the light emitting element 330. In some cases, such a second connection electrode 361 may be connected to another second connection electrode by the second electrode 360.

The foregoing description is merely illustrative of the present invention, and various modifications and variations may be made by those skilled in the art to which the present invention pertains without departing from the essential features of the present invention.

Accordingly, the embodiments disclosed herein are intended to illustrate the present invention and not to limit the present invention, and the scope of the present invention is not limited by such embodiments.

The scope of protection of the present invention shall be determined by the appended claims, and all modifications and equivalents falling within the scope of the claims are intended to be included within the scope of the present invention.

### [Industrial Availability]

According to the present invention, a semiconductor light-emitting device such as a micro-LED and a display device using the same can be provided.

## Claims

1. A transfer substrate assembly configured to transfer a light emitting element, the transfer substrate assembly comprising:
a transfer substrate including a first surface where a rough surface is formed;
an adhesive layer locally positioned on the first surface of the transfer substrate; and
a light emitting element attached by the adhesive layer.

2. The transfer substrate assembly of claim 1, further comprising a sacrificial layer disposed between the adhesive layer and the light emitting element.

3. The transfer substrate assembly of claim 2, wherein a width or a diameter of the sacrificial layer is greater than a width or a diameter of the adhesive layer.

4. The transfer substrate assembly of claim 2, wherein a width or a diameter of the sacrificial layer is equal to or smaller than a width or a diameter of a contact surface of the light emitting element.

5. The transfer substrate assembly of claim 1, wherein the transfer substrate is a sapphire substrate.

6. The transfer substrate assembly of claim 5, wherein the rough surface is a surface obtained by wet-etching a first surface of the sapphire substrate.

7. The transfer substrate assembly of claim 1, wherein the rough surface includes an uneven pattern increasing a surface area of the first surface of the transfer substrate.

8. A method for manufacturing a display device including a light emitting element, the method comprising:
forming a sacrificial layer on an individual light emitting element separately partitioned on a growing substrate;
forming an adhesive layer on the sacrificial layer;
attaching the adhesive layer to a first surface of a transfer substrate where a rough surface is formed; and
removing the growing substrate.

9. The method of claim 8, further comprising removing the sacrificial layer to separate the individual light emitting element from the first surface of the transfer substrate.

10. The method of claim 9, wherein the removing of the sacrificial layer includes etching the sacrificial layer in a fluid to disperse the individual light emitting element into the fluid.

11. The method of claim 8, wherein a width or a diameter of the sacrificial layer is greater than a width or a diameter of the adhesive layer.

12. The method of claim 8, wherein a width or a diameter of the sacrificial layer is equal to or smaller than a width or a diameter of a contact surface of the light emitting element.

13. The method of claim 8, wherein the transfer substrate is a sapphire substrate.

14. The method of claim 13, wherein the rough surface is a surface obtained by wet-etching a first surface of the sapphire substrate.

15. The method of claim 8, wherein the rough surface includes an uneven pattern increasing a surface area of the first surface of the transfer substrate.
